# EUROPÄISCHE PATENTSCHRIFT

(11) **EP 2 025 210 B1**
(45) Veröffentlichungstag und Bekanntmachung des Hinweises auf die Patenterteilung: **22.02.2012**
(21) Anmeldenummer: 07718465.3
(22) Anmeldetag: 25.05.2007
(51) Int. Cl.: H05K 1/05, H05K 3/28, H05K 3/44, C03C 3/064, C23C 4/18

(54) **SCHALTUNGSTRÄGER**
CIRCUIT CARRIER
SUPPORT DE CIRCUIT

(30) Priorität: 07.06.2006 AT 9732006
(43) Veröffentlichungstag der Anmeldung: 18.02.2009
(73) Patentinhaber: A.B. Mikroelektronik Gesellschaft mit beschränkter Haftung, 5020 Salzburg (AT)
(72) Erfinder: HAEGELE, Bernd, 84529 Tittmoning (DE)
(74) Vertreter: Gangl, Markus
(86) Internationale Anmeldenummer: PCT/AT2007/000254
(87) Internationale Veröffentlichungsnummer: WO 2007/140494

(56) Entgegenhaltungen:
- WO-A-97/13274
- DE-A1- 3 201 430
- US-A- 3 202 591
- US-A- 3 340 164
- US-A- 3 340 164
- "SELECTIVELY SEALING POROSITY AND CRACKS IN ANODIZED ALUMINUM FOR DIELECTRIC PROTECTION", IBM TECHNICAL DISCLOSURE BULLETIN, INTERNATIONAL BUSINESS MACHINES CORP. (THORNWOOD), US, vol. 32, no. 4B, 1 September 1989 (1989-09-01), page 158, XP000067033, ISSN: 0018-8689

## Beschreibung

Die vorliegende Erfindung betrifft einen Schaltungsträger mit einer metallischen Trägerschicht, auf der zumindest bereichsweise eine dielektrische Schicht angeordnet ist, wobei die dielektrische Schicht eine Vielzahl von Poren aufweist, wobei die Poren zumindest auf der von der Trägerschicht abgewandten Seite der dielektrischen Schicht mit einem Glas versiegelt sind.

Derartige Schaltungsträger werden vorrangig im Bereich der Leistungselektronik, insbesondere im Bereich von Hochtemperaturanwendungen wie dem Motorraum von Kraftfahrzeugen, eingesetzt.

Ein Träger für Elektronikkomponenten mit den Merkmalen des Oberbegriffs von Anspruch 1 geht aus der WO 97/13274 A1 hervor.

Der Betrieb jeder elektrischer bzw. elektronischer Schaltung ist mit der Entstehung von Abwärme verbunden, welche, um einer Beeinträchtigung des Betriebs bzw. einer Zerstörung der Schaltung vorzubeugen, so schnell wie möglich abgeführt werden muss. Insbesondere Leistungselektronik zeichnet sich im Betrieb durch eine sehr große Menge von Abwärme aus. Erschwerend kommt bei Hochtemperaturanwendungen noch die relativ hohe Umgebungstemperatur von über 100 °C (beispielsweise ca. 150 °C in gewissen Bereichen des Motorraums von Kraftfahrzeugen) hinzu. Um eine möglichst rasche Ableitung der Abwärme zu erreichen, werden die elektrischen bzw. elektronischen Schaltungen auf Schaltungsträgern angebracht, deren metallisches Trägermaterial als Kühlkörper für die Schaltung fungieren kann.

Die Schicht aus dielektrischen Material, welche meist sehr viel dünner ausgebildet ist als jene aus metallischem Material, dient vor allem dazu, die einzelnen Leiterbahnen, welche auf der Schicht aus dielektrischem Material angeordnet sind, vom metallischen Trägermaterial elektrisch zu isolieren. Daneben kann ein dielektrisches Material gewählt werden, welches sich durch einen sehr niedrigen Wärmeübergangswiderstand auszeichnet, sodass die Abwärme von elektrischen bzw. elektronischen Bauteilen, welche auf der Schicht aus dielektrischem Material angeordnet sind, so schnell wie möglich über das metallische Trägerelement abgeführt werden kann.

Die dielektrische Schicht kann nach ihrer Herstellung eine Vielzahl von Poren aufweisen. Aus verschiedenen Gründen kann es notwendig sein, diese Poren mit einem Siegelmaterial zu versiegeln. Beispielsweise beeinträchtigt das Vorhandensein von Poren das elektrische Isolationsvermögen der Schicht aus dielektrischem Material, was insbesondere in einer feuchten Arbeitsumgebung problematisch sein kann. Durch das Eindringen von Feuchtigkeit in die Poren kann es zu elektrischen Kurzschlüssen zwischen den Leiterbahnen und dem metallischen Trägermaterial kommen.

Je nach Herstellungsverfahren tritt das Problem der Ausbildung von Poren unterschiedlich massiv auf. Besonders Herstellungsverfahren, bei welchen die Schicht aus dielektrischem Material in einem thermischen Spritzverfahren auf das metallische Trägermaterial aufgebracht wird, sind mit dem Problem der Ausbildung von Poren behaftet.

Derartige Verfahren sind beispielsweise in der GB 990 023, GB 1 461 031 und EP 115 412 A2 beschrieben. Obwohl sich das thermische Spritzverfahren an sich sehr gut für die Aufbringung des dielektrischen Materials auf das metallische Trägermaterial eignet, tritt doch das Problem auf, dass die aufgespritzte Schicht aus dielektrischem Material eine Vielzahl von Poren aufweist, was das elektrische Isolationsvermögen der Schicht aus dielektrischem Material erheblich verringern kann. Besonders problematisch ist das Vorhandensein der Poren in einer feuchten Umgebung.

Beispielsweise beschreibt die EP 48 992 A2 ein Verfahren, bei welchem nach dem thermischen Aufspritzen der Schicht aus dielektrischem Material ein Harz zum Versiegeln der Poren auf die Schicht aus dielektrischem Material aufgestrichen wird. Aus der DE 195 29 627 C1 geht ebenfalls das Versiegeln der Poren durch das Aufbringen eines Epoxidharzes hervor. Daneben ist auch das Versiegeln der Poren durch eine im Temperaturbereich zwischen 600 °C und 800 °C schmelzende Keramikglasur beschrieben.

Der Einsatz von Harzen ist insofern nachteilig, als es sich um ein relativ aufwendiges Verfahren handelt, da die Harze in einer geeigneten Form (beispielsweise durch Polymerisierung - siehe EP 48 992 A2) gehärtet werden müssen. Die in der DE 195 29 627 C1 zusätzlich beschriebene Aufbringung einer Keramikglasur ist insofern nachteilig, als die bei den angegebenen Temperaturen schmelzende Keramikglasur, welche aus dem Porzellangewerbe stammt, stark bleihältig ist und damit in den meisten Ländern nicht mehr angewendet werden darf. Weiters hat sich herausgestellt, dass eine derartige Keramikglasur häufig selbst porös ist, sodass der auf die Schicht aus dielektrischem Material aufgebrachte Film selbst Löcher haben kann. In diesem Fall ist das Problem des Auftretens von Kurzschlüssen überhaupt nicht behoben.

Aufgabe der Erfindung ist es, einen Schaltungsträger bereitzustellen, welcher die oben angeführten Nachteile des Standes der Technik vermeidet.

Diese Aufgabe wird durch einen Schaltungsträger mit den Merkmalen des Anspruchs 1 dadurch gelöst, dass die Oberfläche der von der Trägerschicht abgewandten Seite der dielektrischen Schicht außerhalb des Bereichs der mit Glas versiegelten Poren im Wesentlichen frei von Glas ist. Dies kann entweder durch Entfernen des Glases von der Oberfläche der dielektrischen Schicht oder im Falle des Einsatzes eines thermischen Spritzverfahrens durch die Wahl geeigneter Verfahrensparameter erreicht werden.

Der erfindungsgemäß vorgesehene Einsatz eines Glases als Siegelmaterial weist gegenüber dem Einsatz von Harzen den Vorteil auf, dass das Glas nicht in einem gesonderten Arbeitsgang gehärtet werden muss.

Beispielsweise kann vorgesehen sein, das Glas in einem thermischen Spritzverfahren aufzubringen. Vorzugsweise erfolgt dies gleichzeitig mit dem thermischen Aufspritzen der Schicht aus dielektrischem Material (kurz: dielektrische Schicht). In beiden Fällen erfolgt die Erstarrung des Glases automatisch durch Abkühlung.

Es kann auch vorgesehen sein, dass das Glas auf die Schicht aus dielektrischem Material aufgestrichen oder aufgedruckt (zum Beispiel im Siebdruckverfahren) wird. In diesem Fall kann die Aushärtung in einem Ofen erfolgen.

Gegenüber der im Stand der Technik beschriebenen Aufbringung einer Keramikglasur weist die Verwendung von Glas den Vorteil auf, dass dieses nicht Bleihaltig sein muss und außerdem nach der Aufbringung selbst keine Löcher aufweist.

Auf der versiegelten dielektrischen Schicht können in bekannter Weise Leiterbahnen aufgebracht sein. Der fertige Schaltungsträger kann elektrische und/oder elektronische Bauteile aufweisen. Zur Erzeugung von Leiterbahnen kann eine leitfähige Paste auf die dielektrische Schicht aufgebracht und anschließend eingebracht werden. Das Aufbringen der Paste kann vorzugsweise im Siebdruck oder Jetverfahren erfolgen.

Beispielsweise kann für die dielektrische Schicht ein Keramikmaterial, vorzugsweise Aluminiumoxid (Al₂O₃) oder Aluminiumnitrit (AIN) verwendet werden.

Beispielsweise kann vorgesehen sein, dass das verwendete Glas aus Dibismuttrioxid, Aluminiumoxid, Siliziumdioxid oder Dibortrioxid oder einem Gemisch aus zwei oder mehreren dieser Komponenten besteht. In einem möglichen Ausführungsbeispiel kann vorgesehen sein, dass das verwendete Glas aus 55 % Dibismuttrioxid, 21 % Aluminiumoxid, 14 % Siliziumdioxid und 10 % Dibortrioxid besteht. Geeignete Gläser können zum Beispiel von der Ferro Corporation, 1000 Lakeside Avenue, Cleveland, Ohio 44114-7000, USA (www.ferro.com) bezogen werden.

Das gewünschte Versiegeln der Poren kann mit einer Menge an Siegelmaterial (Glas) von etwa 5 % bis 30 % der Gesamtmenge von dielektrischem Material und Siegelmaterial (Glas) erreicht werden.

Die metallische Trägerschicht kann beispielsweise aus Aluminium oder Kupfer bestehen.

Wird als thermisches Spritzverfahren das Plasmaspritzen gewählt, sollte darauf geachtet werden, dass das meist in Pulverform vorliegende Siegelmaterial mit einer solchen Korngröße und Schmelztemperatur gewählt wird, dass das Siegelmaterial bis zur notwendigen Spritztemperatur, beispielsweise 2100 °C, verbrennungsfrei auf das metallische Trägermaterial gespritzt werden kann.

Beispielsweise können Al₂O₃-Pulver mit Partikelgrößen von 5 µm bis 60 µm (typischer Weise 5,6 µm oder 22,5 µm) und eine Schmelztemperatur von 2050° C verwendet werden.

In allen Ausführungsbeispielen ist vorzugsweise vorgesehen, dass die Schicht aus metallischem Trägermaterial gleichzeitig als mechanisch (starrer) Träger aller Komponenten des Schaltungsträgers fungiert.

Weitere Vorteile und Einzelheiten der einzelnen Ausführungsformen der Erfindung ergeben sich anhand der Figuren sowie der dazugehörigen Figurenbeschreibungen. Dabei zeigen:
- Fig. 1: schematisch eine Vorrichtung zur Durchführung eines erfindungsgemäßen Verfahrens und
- Fig. 2a, 2b, 2c: einen mit dem erfindungsgemäßen Verfahren hergestellten Schaltungsträger in Draufsicht, Seitendarstellung und in einer Detailansicht.

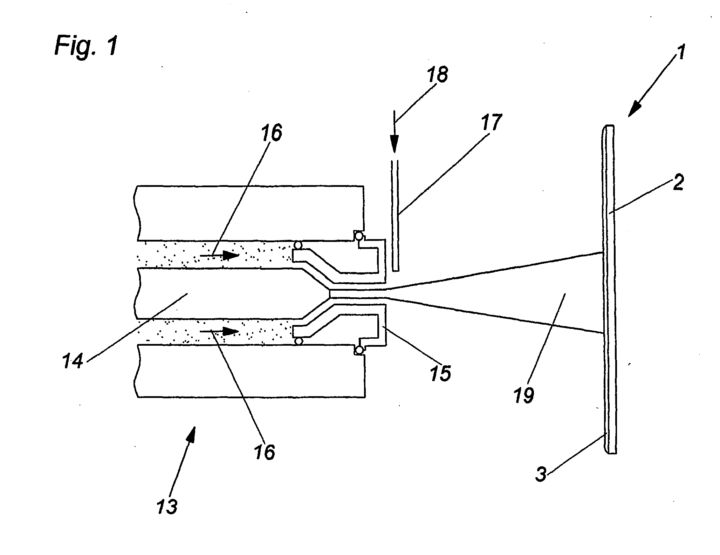

Fig. 1 zeigt das thermische Aufspritzen einer Schicht 3 aus dielektrischem Material auf eine Schicht 2 aus metallischem Trägermaterial eines Schaltungsträgers 1. Schematisch dargestellt ist eine Plasmakanone 13 mit einer Kathode 14 und einer Anode 15. Die Pfeile 16 deuten die Zuführung von Plasmagas an. Durch eine Hochfrequenzzündung kommt es zur Ausbildung eines Lichtbogens zwischen der Kathode 14 und der Anode 15, was zur Ionisierung des Plasmagases führt. Das so entstandene Plasma verlässt die Brenndüse mit hohen Geschwindigkeiten (ca. 300 bis 700 m/s) und mit Temperaturen von ca. 15000 bis 20000 °C. Über eine Einbringungsvorrichtung 17 wird das auf die Schicht 2 aufzubringende Material (dargestellt durch den Pfeil 18) in den Plasmastrahl eingebracht, wo es durch diesen aufgeschmolzen und auf eine hohe Geschwindigkeit beschleunigt wird. Das aufgeschmolzene Material trifft mit einer hohen Geschwindigkeit auf die metallische Trägerschicht 2 auf (Strahl 19) und lagert sich dort als Schicht 3 aus dielektrischem Material (kurz: dielektrische Schicht 3) ab. Bei einer bevorzugten Ausführungsform wird ein Gemenge aus dem Siegelmaterial (Glas 9) und dem dielektrischen Material gemeinsam über die Einbringungsvorrichtung 17 in den Plasmastrahl eingebracht.

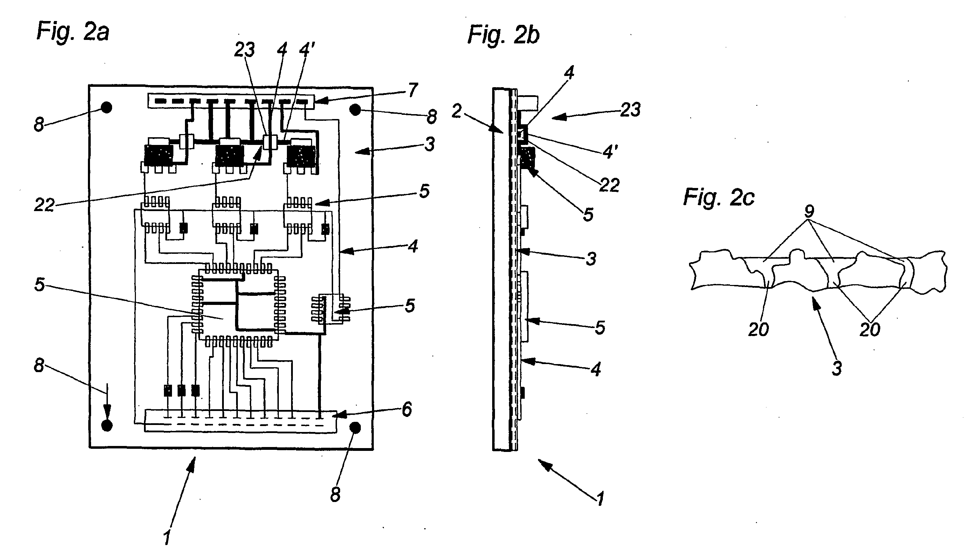

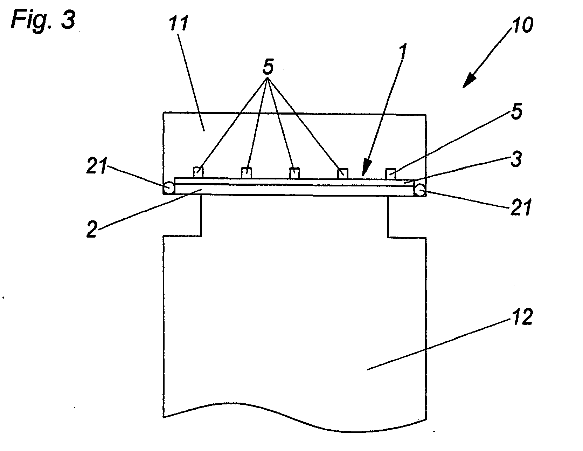

Fig. 2a zeigt in Draufsicht beispielhaft einen Schaltungsträger 1 auf dessen Schicht 3 aus dielektrischem Material Leiterbahnen 4 sowie elektrische bzw. elektronische Bauteile 5 angebracht sind. In diesem Ausführungsbeispiel besteht die metallische Trägerschicht 2 aus Aluminium, welche vor dem thermischen Bespritzen mittels Sandstrahltechnik gereinigt und angeraut wurde. An den vier Ecken der metallischen Trägerschicht 2 sind Bohrungen 8 angeordnet, über die der Schaltungsträger 1 später verschraubt werden kann. In Fig. 2a sind weiters eine vierundzwanzigpolige Steckerleiste 6 sowie eine neunpolige Steckerleiste 7 erkennbar. Bei den dargestellten elektrischen bzw. elektronischen Bauteilen 6 handelt es sich um einen Mikrokontroller, Regler, Treiberschaltkreise, Leistungstransistoren und Widerstände.

Die Leiterbahnen 4 wurden nach dem thermischen Aufspritzen der dielektrischen Schicht 3 aufgedruckt und anschließend bei Temperaturen zwischen 400 °C und 530 °C gesintert. Auf die gedruckten Leiterbahnen 4 wurde anschließend mittels Schablonendruck eine Lotpastenschicht aufgetragen, in die dann die elektrischen bzw. elektronischen Bauteile 5 hineinbestückt wurden.

Die bestückten Bauteile 5 und die Steckerleisten 6, 7 wurden gleichzeitig auf dem Schaltungsträger 1 verlötet.

Um eine ideale Abfuhr der Abwärme der elektrischen bzw. elektronischen Bauteile 5 zu erzielen, wurden alle elektrischen bzw. elektronischen Bauteile 5 unmittelbar, das heißt ohne Zwischenträger, auf dem Schaltungsträger 1 (auf dessen dielektrische Schicht 3) montiert.

In Fig. 2b ist der Schichtaufbau eines erfindungsgemäßen Schaltungsträgers 1 dargestellt. Diese Darstellung ist selbstverständlich nicht maßstabsgerecht. Beispielsweise kann die Dicke der metallischen Trägerschicht 2 bis zu 10 mm (typisch 1-5 mm) betragen, während die dielektrische Schicht 3 üblicherweise eine Dicke von 30 µm bis 70 µm aufweist.

Fig. 2c zeigt eine Detailsicht des in den Fig. 2a und 2b dargestellten Schaltungsträgers 1 im Bereich der dielektrischen Schicht 3. Erkennbar sind in der dielektrischen Schicht 3 angeordnete Poren 20, welche durch ein Glas 9 versiegelt sind. Erkennbar ist weiters, dass erfindungsgemäß die Oberfläche der dielektrischen Schicht 3 außerhalb des Bereichs der Poren 20 im Wesentlichen frei von Glas 9 ist.

## Patentansprüche

1. Schaltungsträger (1) mit einer metallischen Trägerschicht (2), auf der zumindest bereichsweise eine dielektrische Schicht (3) angeordnet ist, wobei die dielektrische Schicht (3) eine Vielzahl von Poren (20) aufweist, wobei die Poren (20) zumindest auf der von der Trägerschicht (2) abgewandten Seite der dielektrischen Schicht (3) mit einem Glas (9) versiegelt sind, **dadurch gekennzeichnet, dass** die Oberfläche der von der Trägerschicht (2) abgewandten Seite der dielektrischen Schicht (3) außerhalb des Bereichs der mit Glas (9) versiegelten Poren (20) im Wesentlichen frei von Glas (9) ist.

2. Schaltungsträger nach Anspruch 1, **dadurch gekennzeichnet, dass** auf der dielektrischen Schicht (3) Leiterbahnen (4, 4') angeordnet sind.

3. Schaltungsträger nach einem der Ansprüche 1 oder 2, **dadurch gekennzeichnet, dass** am Schaltungsträger (1) elektrische und/oder elektronische Bauteile (5) angebracht sind.

4. Schaltungsträger nach einem der Ansprüche 1 bis 3, **dadurch gekennzeichnet, dass** das Material der dielektrischen Schicht (3) ein Keramikmaterial, vorzugsweise Aluminiumoxid (Al₂O₃) oder Aluminiumnitrid (AlN), ist.

5. Schaltungsträger nach einem der Ansprüche 1 bis 4, **dadurch gekennzeichnet, dass** das Glas (9) aus Dibismuttrioxid, Aluminiumoxid, Siliziumdioxid oder Dibortrioxid oder einem Gemisch aus zwei oder mehreren dieser Komponenten besteht.

6. Schaltungsträger nach Anspruch 5, **dadurch gekennzeichnet, dass** das Glas (9) aus 55 % Dibismuttrioxid, 21 % Aluminiumoxid, 14 % Siliziumdioxid und 10 % Dibortrioxid besteht.

7. Schaltungsträger nach einem der Ansprüche 1 bis 6, **dadurch gekennzeichnet, dass** die Menge an Glas (9) etwa 5 % - 30 % der Gesamtmenge von dielektrischen Material und Glas (9) beträgt.

## Claims

1. A circuit carrier (1) having a metallic carrier layer (2) on which a dielectric layer (3) is arranged in at least region-wise manner, wherein the dielectric layer (3) has a plurality of pores (20), wherein the pores (20) are sealed with a glass (9) at least on the side of the dielectric layer (3) that is remote from the carrier layer (2), **characterised in that** the surface of the side of the dielectric layer (3) that is remote from the carrier layer (2) is substantially free from glass (9) outside the region of the pores (20) sealed with glass (9).

2. A circuit carrier as set forth in claim 1, **characterised in that** conductor tracks (4, 4') are arranged on the dielectric layer (3).

3. A circuit carrier as set forth in claim 1 or claim 2, **characterised in that** electrical and/or electronic components (5) are mounted on the circuit carrier (1).

4. A circuit carrier as set forth in one of claims 1 through 3, **characterised in that** the material of the dielectric layer (3) is a ceramic material, preferably aluminum oxide (Al₂O₃) or aluminum nitride (AlN).

5. A circuit carrier as set forth in one of claims 1 through 4, **characterised in that** the glass (9) comprises dibismuth trioxide, aluminum oxide, silicon dioxide or diboron trioxide or a mixture of two or more of those components.

6. A circuit carrier as set forth in claim 5, **characterised in that** the glass (9) comprises 55% dibismuth trioxide, 21% aluminum oxide, 14% silicon dioxide and 10% diboron trioxide.

7. A circuit carrier as set forth in claims 1 through 6, **characterised in that** the amount of glass (9) is between about 5% and 30% of the total amount of dielectric material and glass (9).

## Revendications

1. Support de circuit (1) avec une couche support (2) métallique sur laquelle est disposée au moins par zones une couche diélectrique (3), la couche diélectrique (3) présentant une multiplicité de pores (20), les pores (20) étant scellés par un verre (9) au moins sur le côté de la couche diélectrique (3) qui est éloigné de la couche support (2), **caractérisé en ce que** la surface du côté de la couche diélectrique (3) qui est éloigné de la couche support (2) est essentiellement exempte de verre (9) à l'extérieur de la zone des pores (20) scellés par le verre (9).

2. Support de circuit selon la revendication 1, **caractérisé en ce que** des pistes conductrices (4, 4') sont disposées sur la couche diélectrique (3).

3. Support de circuit selon l'une des revendications 1 ou 2, **caractérisé en ce que** des composants (5) électriques et/ou électroniques sont placés sur le support de circuit (1).

4. Support de circuit selon l'une des revendications 1 à 3, **caractérisé en ce que** le matériau de la couche diélectrique (3) est un matériau céramique, de préférence de l'oxyde d'aluminium (Al₂O₃) ou du nitrure d'aluminium (AIN).

5. Support de circuit selon l'une des revendications 1 à 4, **caractérisé en ce que** le verre (9) est composé de trioxyde de dibismuth, d'oxyde d'aluminium, de dioxyde de silicium ou de trioxyde de dibore ou d'un mélange de deux ou de plusieurs de ces composants.

6. Support de circuit selon la revendication 5, **caractérisé en ce que** le verre (9) se compose à 55 % de trioxyde de dibismuth, à 21 % d'oxyde d'aluminium, à 14 % de dioxyde de silicium et à 10 % de trioxyde de dibore.

7. Support de circuit selon l'une des revendications 1 à 6, **caractérisé en ce que** la quantité de verre (9) représente environ 5 % - 30 % de la quantité totale de matériau diélectrique et de verre (9).
